# EUROPEAN PATENT APPLICATION

(11) **EP 4 451 311 A1**
(43) Date of publication of application: **23.10.2024**
(21) Application number: 24170758.7
(22) Date of filing: 17.04.2024
(51) Int. Cl.: H01J 37/32

(54) **SUBSTRATE PROCESSING APPARATUS**

(30) Priority: 18.04.2023 KR 20230050730
(71) Applicant: PSK Inc., Hwaseong-si, Gyeonggi-do 18849 (KR)
(72) Inventor: YOO, Kwang Sung, 18849 Hwaseong-si (KR)
(74) Representative: Dragotti & Associati S.R.L.

(57) **Abstract**

A substrate processing apparatus includes a housing, a chuck supporting a substrate, a dielectric plate spaced apart from the chuck with the substrate therebetween, a gas supply unit configured to supply a process gas for plasma processing an edge region of the substrate, a protective cover covering an entire lower surface of the dielectric plate, attachable to and detachable from the dielectric plate, and protecting the dielectric plate from the plasma, and a coupling portion attaching and detaching the protective cover to and from the dielectric plate.

## Description

### CROSS-REFERENCE TO RELATED APPLICATION

This application is based on and claims priority under 35 U.S.C. §119 to Korean Patent Application No. 10-2023-0050730, filed on April 18, 2023, in the Korean Intellectual Property Office, the disclosure of which is incorporated by reference herein in its entirety.

### BACKGROUND

### 1. Field

The disclosure relates to a substrate processing apparatus, and more particularly, to a substrate processing apparatus for processing a substrate by using plasma.

### 2. Description of the Related Art

Plasma refers to an ionized gaseous state including ions, radicals, electrons, and the like. Plasma may be generated by excessively high temperatures, strong electric fields, or radio frequency (RF) electromagnetic fields. Semiconductor device manufacturing processes may include etching processes of removing thin films from substrates by using plasma. Such etching processes may be performed when ions and radical particles contained in the plasma collide or react with the thin films on the substrates.

Apparatuses for processing substrates by using plasma may supply process gases to processing spaces and excites the process gases to generate plasma. The plasma may collide not only with the substrates but also with components within housings. Components or the like included in substrate processing apparatuses may collide with the plasma and be etched.

### SUMMARY

Provided is a substrate processing apparatus capable of reducing damage to components due to reaction to plasma.

Provided is a substrate processing apparatus including a protective cover that may be easily replaced.

Provided is a substrate processing apparatus capable of increasing a use life span.

Provide is a substrate processing apparatus capable of providing uniform process performance with respect to a substrate.

Problems to be solved by the disclosure are not limited to the above-described problems, and problems not mentioned may be clearly understood by one of ordinary skill in the art from the description and accompanying drawings.

Additional aspects will be set forth in part in the description which follows and, in part, will be apparent from the description, or may be learned by practice of the presented embodiments of the disclosure.

According to an aspect of the disclosure, a substrate processing apparatus includes a housing defining a processing space, a chuck arranged in the processing space and supporting the substrate, a dielectric plate spaced apart from the chuck with the substrate therebetween, a gas supply unit configured to supply a process gas for plasma processing an edge region of the substrate, a protective cover covering an entire lower surface of the dielectric plate, attachable to and detachable from the dielectric plate, and protecting the dielectric plate from the plasma, and a coupling portion attaching and detaching the protective cover to and from the dielectric plate.

The protective cover may be attached to and detached from the dielectric plate while the dielectric plate is fixed to the housing.

The protective cover may be attached to and detached from the dielectric plate by rotation and vertical movement of the protective cover.

The coupling portion may include a protrusion portion arranged on a side surface of the dielectric plate and protruding outwards, and a guide portion arranged on a side surface region of the protective cover and providing a movement path of the protrusion portion while the protrusion portion is inserted thereinto.

The protrusion may include an elastic material.

A width of the guide portion may be non-uniform.

The guide portion may include a first guide portion including one end exposed at an upper end of the protective cover and extending in a first direction, and a second guide portion including one end connected to an other end of the first guide portion and extending in a second direction different from the first direction.

The first direction may include a direction perpendicular to the lower surface of the protective cover.

The second direction may include a direction parallel to the lower surface of the protective cover.

The first guide portion may have a tapered shape whose width gradually decreases from the upper end of the protective cover to a lower end of the protective cover.

The second guide portion may have a convex shape whose width gradually increases and then decreases again.

The guide portion may include a hole passing from an inner side surface of the protective cover to an outer side surface of the protective cover.

The guide portion may include a trench in which a partial region of the protective cover is recessed.

The protective cover may include a material including at least two of Nd, Pm, Sm, Gd, Y, Sc, Er, F, and O.

The lower surface of the protective cover may be stepped.

The protective cover may include a round surface convex toward the processing space.

A radius of curvature of the round surface may be 10 mm or less.

A gap between the substrate and the protective cover may be adjusted according to the radius of curvature of the round surface.

The gap between the substrate and the protective cover may be inversely proportional to the radius of curvature of the round surface.

The substrate processing apparatus may further include an optical sensor arranged on the housing and configured to acquire the radius of curvature of the round surface by using light.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a view schematically illustrating substrate processing equipment according to an embodiment;
FIG. 2 is a view illustrating an embodiment of a substrate processing apparatus provided in a process chamber of FIG. 1;
FIG. 3 is a block diagram illustrating a controller according to an embodiment;
FIG. 4 is a view illustrating an example in which the substrate processing apparatus of FIG. 2 performs a plasma processing process;
FIG. 5A is a view illustrating a coupling portion for coupling a dielectric plate and a protective cover to each other, according to an embodiment;
FIG. 5B is a view illustrating a portion of a cross-section of the dielectric plate and a protrusion portion of FIG. 5A;
FIG. 6 is a view illustrating a coupling portion including a guide portion having a non-uniform width, according to an embodiment;
FIG. 7 is a view illustrating a coupling portion including a guide portion having a trench shape, according to an embodiment;
FIG. 8 is a view illustrating a substrate processing apparatus including a protective cover having a round surface, according to an embodiment;
FIG. 9 is a view illustrating a substrate processing apparatus including a stepped protective cover, according to an embodiment;
FIG. 10A is view illustrating a substrate processing apparatus including an optical sensor, according to an embodiment;
FIG. 10B is a view schematically illustrating a relationship between a round surface and an optical sensor; and
FIG. 11 is a flowchart illustrating a method of adjusting a gap between a protective cover and a substrate according to a radius of curvature, according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. In the following drawings, the same reference numerals refer to the same components, and the size of each component in the drawings may be exaggerated for clarity and convenience of description. Embodiments described below are merely illustrative, and various modifications may be made from the embodiments.

Hereinafter, when a component is referred to as being "above" or "on" another component, the component may be directly above or below the other component, or on the left or right of the other component by contact and may be above or below the other component, or on the left or right of the other component without contact. The singular forms are intended to include the plural forms as well, unless the context clearly indicates otherwise. When a portion is intended to "include" a component, this may mean that the component may further include other components rather than excluding the other components unless otherwise stated.

The use of the term "the" and indicative terms similar thereto may correspond to both the singular and plural forms. Unless the order of operations constituting a method is clearly stated or stated to the contrary, the operations may be performed in any appropriate order and are not limited to the order described.

The terms "... er", "module", etc. described herein may refer to units that process at least one function or operation and may be implemented as hardware, software, or as a combination of hardware and software.

Connections or connecting units of lines between components illustrated in the drawings illustrate functional connections and/or physical or circuit connections and may be represented in actual apparatuses as alternative or additional various functional connections, physical connections, or circuit connections.

The expression such as "at least one" that precedes a list of elements does not limit the entire list of elements and does not limit individual elements of the list. For example, the expressions such as "at least one of A, B, and C" or "at least one selected from a group consisting of A, B, and C" may be interpreted as A alone, B alone, C alone, or a combination of two or more of A, B, and C, such as ABC, AB, BC, and AC.

When "about" or "substantially" is used in connection with a numerical value, the numerical value involved may be interpreted to include a manufacturing or operating deviation (e.g., ±10 %) around a predefined numerical value. Alternatively, when the terms "generally" and "substantially" are used in relation to geometric shapes, it may be intended that geometric precision is not needed and tolerance for the shapes is within the scope of the present embodiment. Regardless of whether a numerical value or a shape is limited to "about" or "substantially," the values and shape may be interpreted to include a manufacturing or operating deviation (e.g., ±10 %) around the predefined numerical value.

Although the terms, 'first', 'second', etc. may be used herein to describe various elements, these elements should not be limited by these terms. These terms are only used to distinguish one element from another.

The use of all examples or illustrative terms is simply intended to describe the technical spirit in detail, and the scope thereof is not limited by these examples or illustrative terms unless limited by the claims.

Hereinafter, embodiments are described in detail with reference to the accompanying drawings.

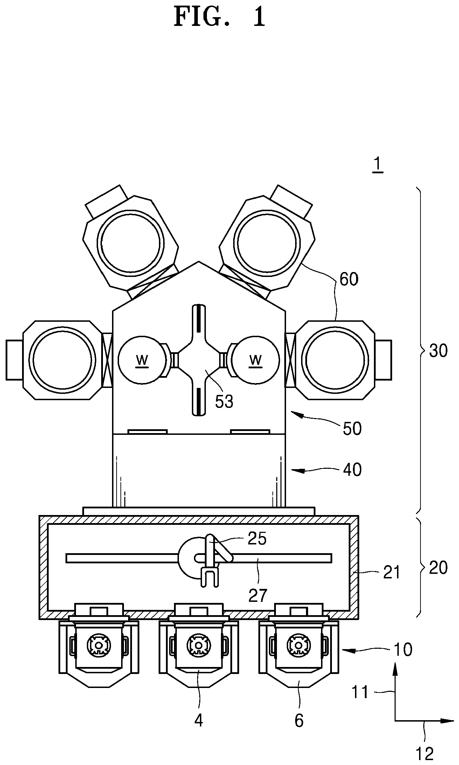

FIG. 1 is a view schematically illustrating substrate processing equipment according to an embodiment. Referring to FIG. 1, substrate processing equipment 1 may include an equipment front end module (EFEM) 20 and a processing module 30. The EFEM 20 and the processing module 30 may be arranged in one direction.

The EFEM 20 may include a load port 10 and a transfer frame 21. The load port 10 may be arranged in front of the EFEM 20 in a first direction 11. The load port 10 may include a plurality of support portions 6. The plurality of support portions 6 may be arranged in a row in a second direction 12, and carriers 4 (e.g., a cassette, a front opening unified pod (FOUP), or the like), which accommodate a substrate W to be provided for a process and a substrate W on which the process is completed may be seated on the support portions 6. The carriers 4 may accommodate the substrate W to be provided for the process and the substrate W on which the process is completed.

The transfer frame 21 may be arranged between the load port 10 and the processing module 30. The transfer frame 21 may include a first transfer robot 25 for transferring the substrate W between the load port 10 and the processing module 30. The first transfer robot 25 may transfer the substrate W between the carrier 4 and the processing module 30 by moving along a transfer rail 27 provided in the second direction 12.

The processing module 30 may include a load lock chamber 40, a transfer chamber 50, and a process chamber 60. The processing module 30 may process the substrate W by receiving the substrate W returned from the EFEM 20.

The load lock chamber 40 may be arranged adjacent to the transfer frame 21. As an example, the load lock chamber 40 may be arranged between the transfer chamber 50 and the EFEM 20. The load lock chamber 40 may provide a space in which the substrate W waits before the substrate W to be provided for the process is transferred to the process chamber 60 or before the substrate W on which the process is completed is transferred to the EFEM 20.

The transfer chamber 50 may transfer the substrate W. The transfer chamber 50 may be arranged adjacent to the load lock chamber 40. The transfer chamber 50 may have a polygonal body when viewed from above. Referring to FIG. 1, the transfer chamber 50 may have a pentagonal body when viewed from above. The load lock chamber 40 and a plurality of process chambers 60 may be arranged along a circumference of the body on an outer surface of the body. Passages (not shown) through which the substrates W enter and exit may be formed in respective sidewalls of the body, and the passages may connect the transfer chamber 50 to the load lock chamber 40 or the process chambers 60. Each passage may be provided with a door (not shown) for opening and closing the passage to seal the inside thereof.

A second transfer robot 53, which transfers the substrate W between the load lock chamber 40 and the process chambers 60, may be arranged in an inner space of the transfer chamber 50. The second transfer robot 53 may transfer the unprocessed substrate W waiting in the load lock chamber 40 to the process chamber 60, or transfer the processed substrate W to the load lock chamber 40. Alternatively, the second transfer robot 53 may carry the substrate W into a processing space 102 of a housing 100 described below or take the substrate W out of the processing space 102.

Alternatively, the second transfer robot 53 may transfer the substrate W between the process chambers 60 to sequentially provide the substrate W to the plurality of process chambers 60. As illustrated in FIG. 1, when the transfer chamber 50 has a pentagonal body, the load lock chamber 40 may be arranged on a sidewall of the transfer chamber 50 adjacent to the EFEM 20, and the process chambers 60 may be consecutively arranged on the remaining sidewalls of the transfer chamber 50. The transfer chamber 50 may be provided in various shapes according to a needed process module, in addition to the above shapes.

The process chambers 60 may be arranged adjacent to the transfer chamber 50. The process chambers 60 may be arranged along a circumference of the transfer chamber 50. A plurality of process chambers 60 may be provided. In each process chamber 60, process processing may be performed on the substrate W. The process chamber 60 may receive the substrate W transferred from the second transfer robot 53, perform process processing on the substrate W, and provide the second transfer robot 53 with the substrate W on which process processing is completed. Process processing performed in each process chamber 60 may be different from each other.

Hereinafter, a substrate processing apparatus 1000 for performing a plasma process in the process chamber 60 is described. The substrate processing apparatus 1000 is described as an example of being configured to perform a plasma processing process on an edge region of the substrate W in the process chamber 60. However, the substrate processing apparatus 1000 is not limited thereto and may be equally or similarly applied to various chambers in which processing on the substrate W is performed. The substrate processing apparatus 1000 may be equally or similarly applied to various chambers in which a plasma processing process on the substrate W is performed.

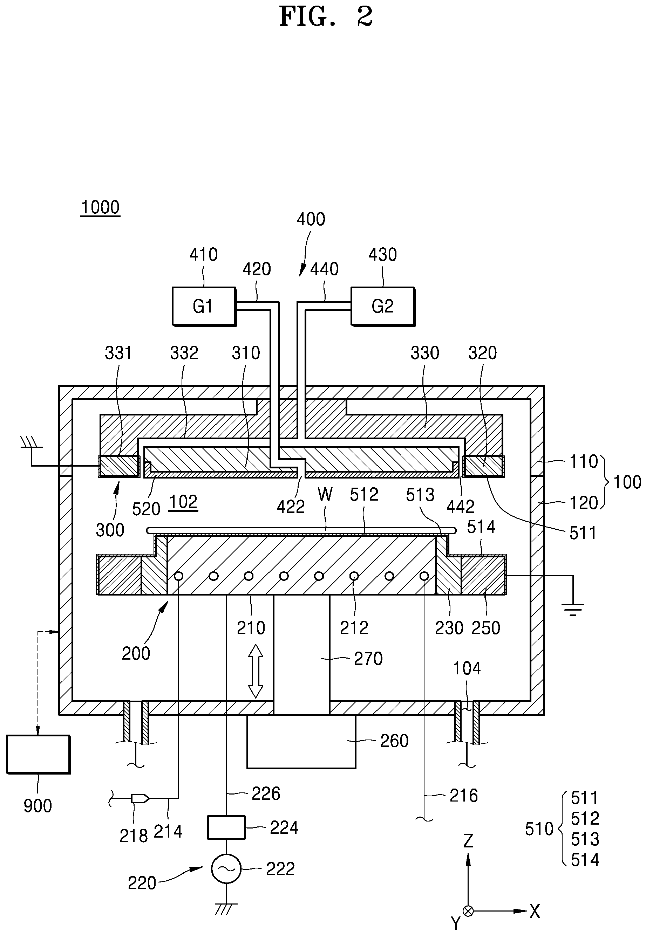

FIG. 2 is a view illustrating an embodiment of a substrate processing apparatus 1000 provided in a process chamber of FIG. 1. Referring to FIG. 2, the substrate processing apparatus 1000 provided in the process chamber 60 may perform a certain process on a substrate W by using plasma. For example, the substrate processing apparatus 1000 may etch or ash a film material on the substrate W.

The film material may be various types of film materials such as a polysilicon film, a silicon oxide film, and a silicon nitride film. Alternatively, the film material may be a natural oxide film or a chemically generated oxide film. The film material may be a byproduct generated in a process of processing the substrate W. The film material may be an impurity that adheres and/or remains on the substrate W.

The substrate processing apparatus 1000 may perform a plasma process on the substrate W. For example, the substrate processing apparatus 1000 may process the substrate W by supplying a process gas and generating plasma from the supplied process gas. The substrate processing apparatus 1000 may process an edge region of the substrate W by suppling a process gas and generate plasma from the supplied process gas. Hereinafter, the substrate processing apparatus 1000 is described as an example of being a bevel etch apparatus that performs etching processing on the edge region of the substrate W.

The substrate processing apparatus 1000 may include a housing 100, a lower electrode unit 200, an upper electrode unit 300, and a gas supply unit 400.

The housing 100 may define a processing space 102. The housing 100 may include an upper housing 110 (or a first housing) and a lower housing 120 (or a second housing). The upper housing 110 and the lower housing 120 may be combined with each other to define the processing space 102. In addition, the upper housing 110 may be rotatably coupled to the lower housing 120 by a rotational coupler (not shown). For example, the upper housing 110 and the lower housing 120 may be coupled to each other by the rotational coupler (not shown) that may be a hinge mechanism.

The upper housing 110 may be at an open location or at a closed location. Hereinafter, a location of the upper housing 110 at which the upper housing 110 is combined with the lower housing 120 to define the processing space 102 may be referred to as the closed location, and a location of the upper housing 110, which exposes the processing space 102 to the outside, may be defined as the open location.

In addition, the atmosphere of the processing space 102 may be isolated from the outside when the upper housing 110 is at the closed position, and the processing space 102 isolated from the outside may be adjusted to a low pressure state (i.e., a vacuum pressure atmosphere) close to vacuum while the substrate W is processed. In addition, the housing 100 may include a material including metal. In addition, an inner surface of the housing 100 may be coated with an insulating material. In addition, the housing 100 may be grounded.

Also, the housing 100 may be a vacuum chamber. For example, an exhaust hole 104 may be formed in a bottom surface of the housing 100. Plasma generated in the processing space 102 or gases G1 and G2 supplied to the processing space 102 may be exhausted to the outside through the exhaust hole 104. In addition, by-products, which are generated in the process of processing the substrate W by using the plasma, may be exhausted to the outside through the exhaust hole 104. Also, the exhaust hole 104 may be connected to an exhaust line (not shown). The exhaust line may be connected to a decompressor that provides decompression. The decompressor may provide decompression to the processing space 102 through the exhaust line.

The lower electrode unit 200 may support the substrate W in the processing space 102. The lower electrode unit 200 may include a chuck 210. The chuck 210 may support the substrate W in the processing space 102. The chuck 210 may have a support surface supporting the substrate W. The chuck 210 may have a circular shape when viewed from above. The chuck 210 may have a smaller diameter than the substrate W when viewed from above. Accordingly, a central region of the substrate W, which is supported by the chuck 210, may be seated on the support surface of the chuck 210, and an edge region of the substrate W may not be in contact with the support surface of the chuck 210.

A heating unit (not shown) may be provided inside the chuck 210. The heating unit (not shown) may heat the chuck 210. The heating unit may be a heater. Alternatively, a cooling passage 212 may be formed in the chuck 210. The cooling passage 212 may be formed inside the chuck 210. A cooling fluid supply line 214 and a cooling fluid discharge line 216 may be connected to the cooling passage 212. The cooling fluid supply line 214 may be connected to a cooling fluid supply source 218. The cooling fluid supply source 218 may store a cooling fluid and/or supply the cooling fluid to the cooling fluid supply line 214. Alternatively, the cooling fluid supplied to the cooling passage 212 may be discharged to the outside through the cooling fluid discharge line 216.

The cooling fluid, which is stored in and/or supplied by the cooling fluid supply source 218, may be cooling water or a cooling gas. Alternatively, a shape of the cooling passage 212, which is formed in the chuck 210, is not limited to the shape illustrated in FIG. 2 and may be variously modified. Alternatively, the component for cooling the chuck 210 is not limited to the component for supplying the cooling fluid, but may be provided as various components (e.g., a cooling plate, and the like) capable of cooling the chuck 210.

The lower electrode unit 200 may further include a power source unit 220. The power source unit 220 may supply radio frequency (RF) power to the chuck 210. The power source unit 220 may include a power source 222, a matcher 224, and a power source line 226. The power source 222 may be a bias power source. Alternatively, the power source 222 may be an RF power source. The power source 222 may be connected to the chuck 210 via the power source line 226. Alternatively, the matcher 224 may be provided to the power line 226 to perform impedance matching.

The lower electrode unit 210 may further include an insulating ring 230. The insulating ring 230 may be provided to have a ring shape when viewed from above. The insulating ring 230 may be configured to surround the chuck 210 when viewed above.

For example, the insulating ring 230 may have a ring shape. The insulating ring 230 may include an insulating material. The insulating ring 230 may electrically isolate a lower edge electrode 250 described below from the chuck 210. The chuck 210 may include a material including metal. The insulating ring 230 may include an insulating material such as ceramic.

In addition, an upper surface of the insulating ring 230 may have a stepped shape. A height of an inner upper surface adjacent to the central region of the substrate W from among the upper surface of the insulating ring 230 may be higher than a height of an outer upper surface far from the central region of the substrate W from among the upper surface of the insulating ring 230. An inflow of plasma described below may be relatively smooth in a region above the outer upper surface of the insulating ring 230, an inflow of the plasma may be blocked or suppressed in a region above the inner upper surface of the insulating ring 230, and thus, processing efficiency for the edge region of the substrate W may further increase.

The lower electrode unit 210 may further include the lower edge electrode 250. The lower edge electrode 250 may be configured to surround the insulating ring 230 when viewed from above. In other words, the lower edge electrode 250 may be arranged to surround the chuck 210 while being insulated from the chuck 210. The lower edge electrode 250 may have a ring shape when viewed from above. The lower edge electrode 250 may be grounded. When viewed from above, the lower edge electrode 250 may be arranged at a location capable of generating plasma in the edge region of the substrate W supported by the chuck 210. For example, the edge region of the substrate W may overlap the lower edge electrode 250 in a thickness direction of the substrate W.

The lower electrode unit 210 may further include an actuator 260 and a shaft 270. The actuator 260 and the shaft 270 may be combined with each other to lift and lower the chuck 210. The shaft 270 may be coupled to the chuck 210. The shaft 270 may be connected to the actuator 260. The actuator 260 may lift and lower the chuck 210 via the shaft 270 in a vertical direction. When the actuator 260 lifts and lowers the chuck 210, a gap between an upper surface of the substrate W supported by the chuck 210 and a protective cover 520 arranged on the upper electrode unit 300 described below may be adjusted.

The upper electrode unit 300 may be provided to face the lower electrode unit 200. The upper electrode unit 300 may be provided to face the upper surface of the substrate W supported by the lower electrode unit 200.

The upper electrode unit 300 may include a dielectric plate 310. The dielectric plate 310 may be arranged to face the upper surface of the substrate W supported by the chuck 210 in the processing space 102. The dielectric plate 310 may be arranged above the lower electrode unit 200. The dielectric plate 310 may include a material including ceramic.

A flow path, which is connected to a first gas supply unit 410 of the gas supply unit 400 described below, may be formed in the dielectric plate 310. A first gas discharge end 422 may be configured such that the first gas G1 supplied by the first gas supply unit 410 is supplied to the central region of the substrate W supported by the lower electrode unit 200. Alternatively, the first gas discharge end 422 may be configured such that the first gas G1 is supplied to an upper surface of the central region of the substrate W supported by a support body 330.

The upper electrode unit 300 may further include an upper edge electrode 320. The upper edge electrode 320 may be arranged to face the lower edge electrode 250. The upper edge electrode 320 may have a ring shape when viewed from above. The upper edge electrode 320 may be a counter electrode facing the lower edge electrode 250.

The upper edge electrode 320 may be provided to surround the dielectric plate 310 when viewed from above. The upper edge electrode 320 may have a ring shape when viewed from above. The upper edge electrode 320 may be provided to be spaced apart from the dielectric plate 310 when viewed from above. An inner circumference of the upper edge electrode 320 and an outer circumference of the dielectric plate 310 may be combined with each other to define a second gas discharge end 442 for supplying a process gas to the edge region of the substrate W.

The upper electrode unit 300 may further include the support body 330. The support body 330 may support the dielectric plate 310 and the upper edge electrode 320. The support body 330 may fix the dielectric plate 310 and the upper edge electrode 320 to the housing 100. The support body 330 may include a material including metal. The support body 330 may be grounded. The support body 330 may be electrically connected to the housing 100 to be grounded. The support body 330 may be combined with the dielectric plate 310 to form a gas channel.

The support body 330 may include an edge lower surface 331 and a middle lower surface 332. The edge lower surface 331 may be adjacent to the edge region of the substrate W viewed from above, and the middle lower surface 332 may be adjacent to the central region of the substrate W. The middle lower surface 332 may be formed to be recessed in a lower surface of the support body 330 in an upward direction. The edge lower surface 331 may generally have a ring shape when viewed from above. The upper edge electrode 320 may be provided on the edge lower surface 331.

The middle lower surface 332 of the support body 330 and the dielectric plate 310 may be combined with each other to define a gas channel. The gas channel may function as a gas flow path through which a process gas supplied from the second gas supply unit 430 flows toward the edge region of the substrate W. The gas channel may be in fluid communication with the processing space 102.

A protective layer 510 may be arranged on a surface of at least one of the lower electrode unit 200 and the upper electrode unit 300. The protective layer 510 may prevent the lower electrode unit 200 and the upper electrode unit 300 from being damaged by plasma. When at least one of the lower electrode unit 200 and the upper electrode unit 300 is damaged and deformed by plasma or impurities such as particles are generated, a process for the substrate W may be affected, and the impurities may adhere to the substrate W to increase a defect rate of the substrate W.

The protective layer 510 may include a different material from the lower electrode unit 200 and the upper electrode unit 300. The protective layer 510 may include a material having greater plasma resistance than the lower electrode unit 200 and the upper electrode unit 300. Here, the plasma resistance may refer to corrosion resistance or erosion resistance.

The protective layer 510 may include a material including at least two of Nd, Pm, Sm, Gd, Y, Sc, Er, F, Al, and O. Alternatively, the protective layer 510 may include a material including at least three of Nd, Pm, Sm, Gd, Y, Sc, Er, F, and O. Alternatively, the protective layer 510 may include at least one of YF₃ and Y₂O₃ as a matrix and may include at least one of Nd, Pm, Sm, Gd, Sc, and Er as a dopant. When more material components are included in the protective layer 510, the plasma resistance may increase by reducing a probability of plasma reaction to a particular material. When more material components are included in the protective layer 510, generation of impurities by plasma may be reduced by increasing sinterability of the protective layer 510.

The protective layer 510 may be coated by an atmosphere plasma spray (APS) method. However, the protective layer 510 is not limited thereto and may be coated by using an aerosol method, a cold spray method, an oxalic acid method, or the like.

As shown in FIG. 2, the protective layer 510 may include a first protective layer 511 arranged on a lower surface and a side surface of the upper edge electrode 320, a second protective layer 512 arranged on an upper surface of the chuck 210, a third protective layer 513 arranged on an upper surface of the insulating ring 230, and a fourth protective layer 514 arranged on an upper surface and a side surface of the lower edge electrode 250. However, the protective layer 510 is not limited thereto and may be arranged at the center of a region in which plasma is concentrated. For example, the protective layer 510 may not include the second protective layer 512 arranged on the upper surface of the chuck 210 of the lower electrode unit 200. Accordingly, when the substrate W is seated on the chuck 210, the plasma is less likely to flow onto the upper surface of the chuck 210.

The first, second, third, and fourth protective layers 511, 512, 513, and 514 may include the same material. However, the disclosure is not limited thereto. For example, the third protective layer 513, which includes at least one of Y₂O₃ and YF₃ as a matrix and includes at least one of Nd, Pm, Sm, Gd, Sc, and Er as a dopant, may be arranged on the insulating ring 230. In addition, the first and fourth protective layers 511 and 514, which include a material including Al₂O₃ as a matrix and at least one of Nd, Pm, Sm, Gd, Sc, and Er as a dopant, may be arranged on the lower edge electrode 250 and the upper edge electrode 320. When the lower edge electrode 250 and the upper edge electrode 320 include metal, the first and fourth protective layers 511 and 514 may also include metal to improve adhesion between the lower edge electrode 250 and the upper edge electrode 320.

When the substrate processing apparatus 1000 operates and the number of processes increases, the protective layer 510 may also be damaged even when a damage rate is slow. When a thickness of the protective layer 510 is too small, a re-coating period of the protective layer 510 may be shortened. Therefore, the protective layer 510 needs to secure the re-coating period longer than a certain period. The thickness of the protective layer 510 according to an embodiment may be about 50 µm or more.

Meanwhile, the protective layer 510 may be arranged on the lower surface of the upper edge electrode 320 and the upper surface of the lower edge electrode 250. When the thickness of the protective layer 510 is too great, formation of an electric field by the upper edge electrode 320 and the lower edge electrode 250 may be inhibited. Accordingly, the thickness of the protective layer 510 may be about 150 µm or less. For example, the thickness of the protective layer 510 may be about 50 µm to about 150 µm or about 80 µm to about 120 µm.

The substrate processing apparatus 1000 according to an embodiment may further include the protective cover 520 that protects the dielectric plate 310 from plasma while covering the entire lower surface of the dielectric plate 310. The protective cover 520 may also include a material having high plasma resistance. For example, the plasma resistance of the protective cover 520 may be greater than the plasma resistance of the dielectric plate 310. For example, the protective cover 520 may include a material including at least two of Nd, Pm, Sm, Gd, Y, Sc, Er, F, and O. Alternatively, the protective cover 520 may include a material including at least three of Nd, Pm, Sm, Gd, Y, Sc, Er, F, and O. Alternatively, the protective cover 520 may include at least one of YF₃ and Y₂O₃ as a matrix and include at least one of Nd, Pm, Sm, Gd, Sc, and Er as a dopant. When more material components are included in the protective cover 520, the plasma resistance may increase by reducing a probability of plasma reaction to a particular material. When more material components are included in the protective cover 520, generation of impurities by plasma may be reduced by increasing sinterability of the protective cover 520.

An average thickness of the protective cover 520 may be greater than an average thickness of the protective layer 510. The average thickness of the protective cover 520 may be several mm. For example, the average thickness of the protective cover 520 may be about 1 mm to about 10 mm or less, but is not limited thereto.

When the substrate processing apparatus 1000 operates and the number of processes increases, the protective cover 520 may also be damaged. In particular, when the substrate processing apparatus 1000 is a bevel etch apparatus that plasma processes an edge of the substrate W, damage to an edge of the protective cover 520 may be the greatest.

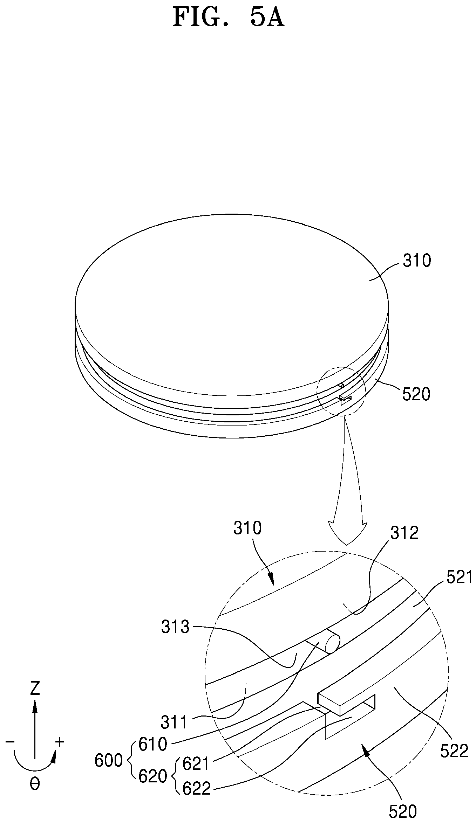

The protective cover 520 according to an embodiment may be attached to and detached from the dielectric plate 310. The substrate processing apparatus 1000 according to an embodiment may further include a coupling portion 600 (referring to FIG. 5A) that attaches and detaches the protective cover 520 to and from the dielectric plate 310. A detailed structure of the coupling portion 600 is described below. The protective cover 520 may be attached to and detached from the dielectric plate 310 while at least one of the dielectric plate 310 and the upper edge electrode 320 is fixed to the housing 100. For example, the protective cover 520 may be attached to and detached from the dielectric plate 310 by rotational motion and vertical movement of the protective cover 520. Therefore, the protective cover 520 may be easily replaced, and maintenance and repair of the substrate processing apparatus 1000 may be convenient.

The gas supply unit 400 may supply a gas to the processing space 102. The gas supply unit 400 may supply the first gas G1 and the second gas G2 to the processing space 102. The gas supply unit 400 may include a first gas supply unit 410, a first gas supply line 420, a second gas supply unit 430, and a second gas supply line 440.

The first gas supply unit 410 may supply the first gas G1 to the processing space 102. The first gas G1 may be an inert gas such as nitrogen or argon. The first gas supply unit 410 may supply the first gas G1 to the central region of the substrate W supported by the chuck 210. The first gas supply unit 410 may supply the first gas G1 to the first gas supply line 420. The first gas supply line 420 may have one end connected to the first gas supply unit 410 and the other end in fluid communication with the first gas discharge end 422 formed in a central region of the dielectric plate 310. The first gas G1 supplied by the first gas supply unit 410 may be supplied to the central region of the substrate W through the first gas supply line 420. The first gas G1 supplied by the first gas supply unit 410 may be supplied to a space between the dielectric plate 310 and the substrate W through the first gas supply line 420.

The second gas supply unit 430 may supply the second gas G2 to the processing space 102. The second gas G2 may be a process gas excited in a plasma state. The second gas G2 may be a process gas in which a plurality of gases of different types are mixed with one another. For example, the second gas supply unit 430 may be configured to supply the second gas G2 including at least two of O₂, N₂, Ar, SF₆, and CF₄. The second gas supply unit 430 may supply the second gas G2 to the second gas supply line 440. The second gas supply line 440 may have one end connected to the second gas supply unit 430 and the other end in fluid communication with the second gas discharge end 442. The second gas G2, which is a mixture gas supplied by the second gas supply unit 430, may be supplied to the edge region of the substrate W through the second gas supply line 440.

The substrate processing apparatus 1000 according to an embodiment may further include a controller 900. The controller 900 may control the substrate processing apparatus 1000 to perform a plasma processing process. For example, the controller 900 may control the gas supply unit 400, the actuator 260, and the like. In detail, the controller 900 may control the gas supply unit 400 so that the power source 222 applies power to the chuck 210 and generates plasma in the edge region of the substrate W supported by the chuck 210 when the first gas supply unit 410 and/or the second gas supply unit 430 supply gases.

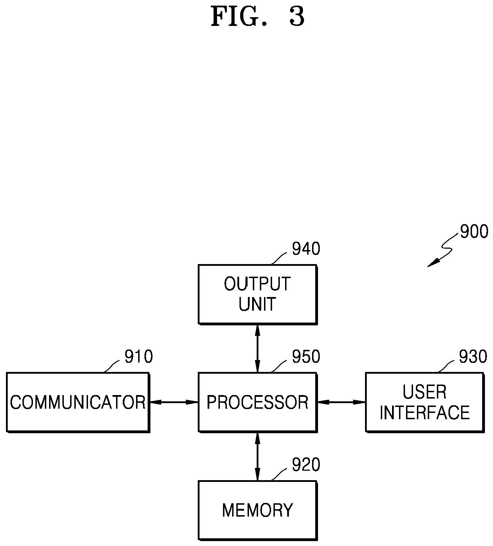

FIG. 3 is a block diagram illustrating the controller 900 according to an embodiment. Referring to FIG. 3, the controller 900 may include a communicator 910 that communicates with the components of the substrate processing apparatus 1000, e.g., the first gas supply unit 410, the second gas supply unit 430, the actuator 260, and the like, a memory 920 that stores a control program executed by the substrate processing apparatus 100, various types of data, a processing recipe, and the like, a user interface 930 that receives a user command of a designer, a worker, or the like using the substrate processing apparatus 1000, an output unit 940 that outputs information regarding a processing process, a current state, and the like of the substrate processing apparatus 1000, and a processor 950 that executes overall control of the substrate processing apparatus 1000.

The communicator 910 may be a wired communication module or a wireless communication module. The user interface 930 may be a keyboard, a button, a touch pad, or the like, and the memory 920 may be a hard disk, a flexible disk such as CD-ROM or DVD, flash memory, or the like. The output unit 940 may be a display, a speaker, a light source, or the like.

The controller 900 may control one substrate processing apparatus 1000 or may control a plurality of substrate processing apparatuses 1000. Alternatively, the controller 900 may overall control not only the substrate processing apparatus 1000 but also the substrate processing equipment 1 shown in FIG. 1.

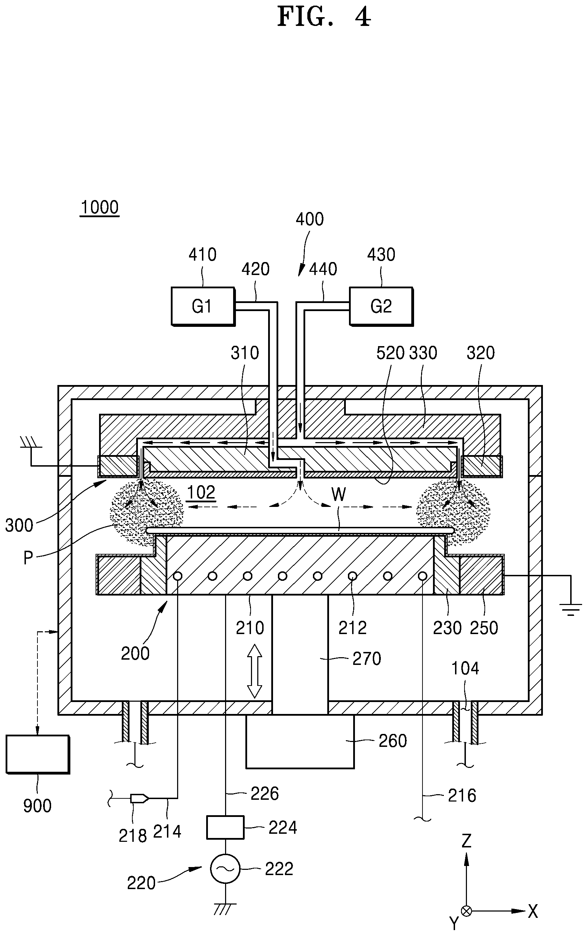

FIG. 4 is a view illustrating an example in which the substrate processing apparatus 1000 of FIG. 2 performs a plasma processing process. Referring to FIG. 4, the substrate processing apparatus 1000 according to an embodiment may generate plasma in an edge region of a substrate W to process the edge region of the substrate W. When the substrate processing apparatus 1000 processes the edge region of the substrate W, a first gas supply unit 410 may supply a first gas G1 to a central region of the substrate W, and a second gas supply unit 430 may supply a second gas G2 to the edge region of the substrate W. The second gas G2 supplied by the second gas supply unit 430 may be a process gas, and thus may be excited in a plasma state to process the edge region of the substrate W. For example, a thin film on the edge region of the substrate W may be etched by plasma.

In addition, the first gas G1 supplied to the central region of the substrate W may be an inert gas, and the first gas G1 may prevent the second gas G2 from flowing onto the central region of the substrate W to further increase processing efficiency for the edge region of the substrate W. A shaft 270 may move a chuck 210 upwards to reduce a gap between the substrate W and a protective cover 520, so that a bevel etch process may be performed on the substrate W.

The plasma generated in the substrate processing apparatus 1000 may etch not only the edge region of the substrate W but also a lower electrode unit 200 and an upper electrode unit 300, and thus, the lower electrode unit 200 and the upper electrode unit 300 may be damaged. In the substrate processing apparatus 1000 according to an embodiment, a protective layer 510 and the protective cover 520, which include a material having high plasma resistance, may be arranged on a surface of at least a portion of the lower electrode unit 200 and the upper electrode unit 300. In particular, the protective cover 520, which is easily attached and detached, may be arranged on a dielectric plate 310 having a high plasma collision possibility.

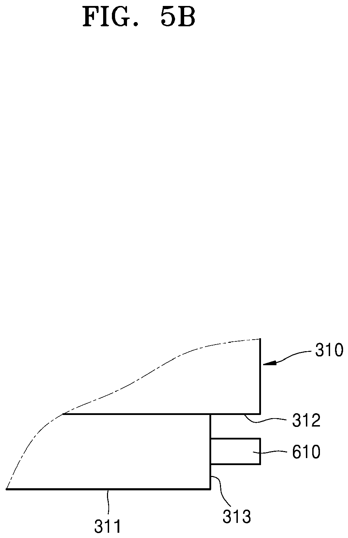

FIG. 5A is a perspective view illustrating a dielectric plate 310, a protective cover 520, and a coupling portion 600 according to an embodiment, and FIG. 5B is a view illustrating a portion of a cross-section of the dielectric plate 310 and a protrusion portion 610 of FIG. 5A. Referring to FIGS. 5A and 5B, the dielectric plate 310 may have a stepped lower surface. For example, the lower surface of the dielectric plate 310 may include a first lower surface 311 and a second lower surface 312 that are parallel to a surface of a substrate (not shown) and have different gaps from the substrate. In addition, the dielectric plate 310 may include a first boundary surface 313 connecting the first lower surface 311 to the second lower surface 312.

The gap between the first lower surface 311 and the substrate and the gap between the second lower surface 312 and the substrate may be different from each other. For example, the gap between the first lower surface 311 and the substrate may be smaller than the gap between the second lower surface 312 and the substrate. When viewed from above, the first lower surface 311 may have a circular shape. Also, the first boundary surface 313 and the second lower surface 312 may have ring shapes. A boundary surface may be perpendicular to a surface direction of the substrate. The first boundary surface 313 may be perpendicular to the surface direction of the substrate, and thus may also be referred to as a side surface of the dielectric plate 310.

The protective cover 520 may include a lower region 521 covering the first lower surface 311 of the dielectric plate 310 and a side surface region 522 covering the first boundary surface 313 and the second lower surface 312 of the dielectric plate 310. Although not shown in FIGS. 5A and 5B, a flow path, which is connected to the gas supply unit 400, may be formed in the lower region 521 of the protective cover 520.

The coupling portion 600 may include the protrusion portion 610 that is arranged on a side surface of the dielectric plate 310, i.e., on the first boundary surface 313 of the dielectric plate 310, and protrudes outwards and a guide portion 620 that is arranged on the side surface region 522 of the protective cover 520 and provides a movement path of the protrusion portion 610 while the protrusion portion 610 is inserted thereinto. The protrusion portion 610 and the guide portion 620 may be complementarily coupled to each other. FIGS. 5A and 5B illustrate one protrusion portion 610 and one guide portion 620, but the disclosure is not limited thereto. A plurality of protrusion portions 610 and a plurality of guide portions 620 may be provided. For example, the plurality of protrusion portions 610 and the plurality of guide portions 620 may be arranged symmetrical to each other on the basis of a central axis of the dielectric plate 310.

The protrusion portion 610 may have a shape protruding outwards from the side surface of the dielectric plate 310, e.g., the first boundary surface 313 of the dielectric plate 310. The protrusion portion 610 may have a pillar shape. A cross-section of the protrusion portion 610 may have a circular shape, but is not limited thereto. The cross-section of the protrusion portion 610 may have various shapes such as an elliptical shape and a polygonal shape. The protrusion portion 610 may include the same material as the dielectric plate 310. The protrusion portion 610 may be formed together when the dielectric plate 310 is formed. However, the protrusion portion 610 is not limited thereto and may be formed by a different process from the dielectric plate 310 and may be adhered to the dielectric plate 310. In addition, the protrusion portion 610 may include a different material from the dielectric plate 310. For example, the protrusion portion 610 may include an elastic material.

The guide portion 620 may be arranged on the side surface region 522 of the protective cover 520 and may provide the movement path of the protrusion 610 while the protrusion portion 610 is inserted thereinto. A width of the guide portion 620 may be greater than or equal to a width of the protrusion portion 610. However, the disclosure is not limited thereto. When the protrusion portion 610 includes an elastic material, the width of the guide portion 620 may be smaller than the width of the protrusion portion 610.

The guide portion 620 may have a hole shape passing from an inner side surface of the protective cover 520 to an outer side surface of the protective cover 520. The guide portion 620 may have a shape bent at least once. For example, the guide portion 620 may include a first guide portion 621 extending in a first direction and a second guide portion 622 extending in a second direction different from the first direction. Lengths of the first guide portion 621 and the second guide portion 622 may be greater than the width of the protrusion portion 610. The lengths of the first guide portion 621 and the second guide portion 622 may be different from each other. For example, the length of the second guide portion 622 may be longer than the length of the first guide portion 621. Therefore, when the protrusion portion 610 is inserted into the second guide portion 622, the first guide portion 621 may prevent the protrusion portion 610 from being easily detached from the second guide portion 622.

The first guide portion 621 may have one end exposed at an upper end of the protective cover 520 and the other end connected to the second guide portion 622. The one end of the first guide portion 621 may be exposed at the upper end of the protective cover 520, and thus, the protrusion portion 610 may be easily inserted into the first guide portion 621. The second guide portion 622 may have one end connected to the other end of the first guide portion 621 and the other end closed by the side surface region 522 of the protective cover 520. The first direction may be a linear direction parallel to an outer circumferential surface of the protective cover 520, and the second direction may be a curved direction parallel to the outer circumferential surface of the protective cover 520. From another viewpoint, the first direction may be a direction (i.e., a Z-axis direction) perpendicular to the lower surface of the protective cover 520, and the second direction may be a direction parallel to the lower surface of the protective cover 520.

When the protrusion portion 610 is inserted through the first guide portion 621 and then the protective cover 520 moves upwards (in a +Z direction), the protrusion portion 610 may move to the other end of the first guide portion 621. In addition, when the protective cover 520 rotates (in a -θ direction), the protrusion portion 610 may move to the other end of the second guide portion 622. When the protrusion portion 610 moves to the other end of the second guide portion 622, the rotation of the protective cover 520 may be stopped, and thus, the protective cover 520 may be fixed to the dielectric plate 310. When the protective cover 520 rotates (in the +θ direction) and moves downwards (in a -Z direction) so that the protrusion portion 610 moves to the one end of the second guide portion 622 and then moves to the one end of the first guide portion 621, the protective cover 520 may be detached from the dielectric plate 310.

By the coupling structure of the protrusion portion 610 and the guide portion 620 described above, the protective cover 520 may be attached to and detached from the dielectric plate 310 while the dielectric plate 310 is fixed to the housing 100. When the dielectric plate 310 is also coated with a protective layer, the dielectric plate 310 needs to be detached from the housing 100 and then combined with the housing 100 again to re-coat the dielectric plate 310. Maintenance and repair costs of the substrate processing apparatus 1000 may be effectively reduced by the protective cover 520 that may be attached to and detached according to an embodiment.

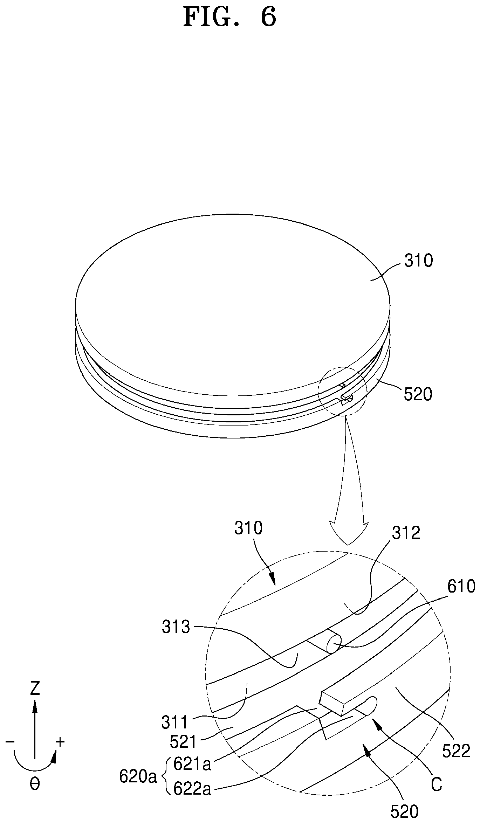

FIG. 6 is a view illustrating a coupling portion including a guide portion 620a having a non-uniform width, according to an embodiment. For brevity of description, the description of FIG. 6, which is substantially the same as the description of FIGS. 5A and 5B, is omitted.

Referring to FIG. 6, a width of the guide portion 620a may not be uniform. A first guide portion 621a may have a tapered shape whose width gradually decreases from an upper end of a protective cover 520 to a lower end of the protective cover 520. For example, a width of one end of the first guide portion 621a may be greater than a width of a protrusion portion 610. The width of the first guide portion 621a may gradually decrease toward the lower end of the protective cover 520, and thus, a width of the other end of the first guide portion 621a may be less than the width of the protrusion portion 610. The width of the one end of the first guide portion 621a may be greater than the width of the protrusion portion 610, and thus, the protrusion portion 610 may be easily introduced into and detached from the first guide portion 621a.

A second guide portion 622a may have a convex shape C whose width gradually increases and then decreases again. The convex shape C may be arranged adjacent to the other end of the second guide portion 622a. When the protrusion portion 610 includes an elastic material, the greatest width of a convex region may be less than the width of the protrusion portion 610. The protrusion portion 610 may move to the first guide portion 621a by vertical movement of the protective cover 520 and then move to the convex region of the second guide portion 622a by rotation of the protective cover 520 and is fixed thereon, and thus, the protective cover 520 may be coupled to a dielectric plate 310. Even when a movement such as shaking occurs in the dielectric plate 310 while the protective cover 520 is coupled to the dielectric plate 310, the protrusion portion 610 may be stably fixed to the convex region C.

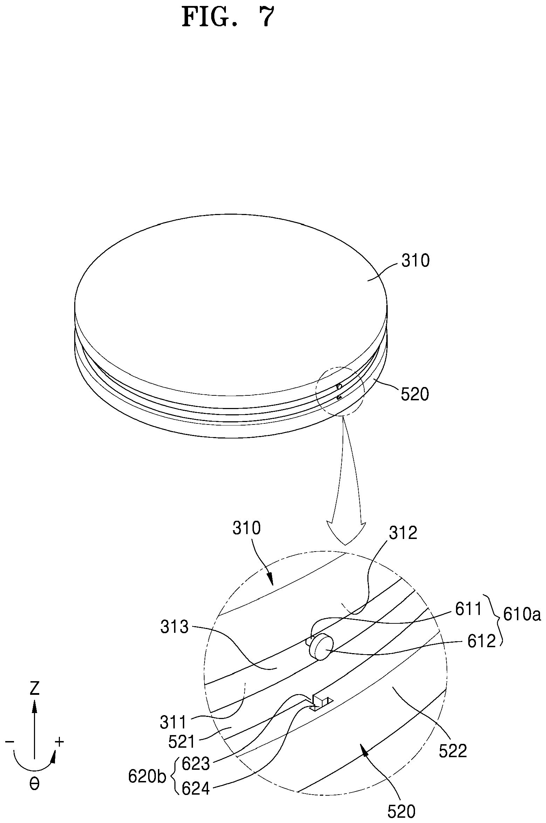

FIG. 7 is a view illustrating a coupling portion including a guide portion 620b having a trench shape, according to an embodiment. For brevity of description, the description of FIG. 7, which is substantially the same as the description of FIGS. 5A and 5B, is omitted.

Referring to FIG. 7, a protrusion portion 610a may include a first region 611 having one end in contact with a side surface of a dielectric plate 310 and protruding from the dielectric plate 310, and a second region 612 having one end in contact with the first region 611 and having a greater width than the first region 611. A guide portion 620b may have a trench shape in which a partial region of a protective cover 520 is recessed. The guide unit 620b may include a third region 623 having a width greater than or equal to the width of the first region 611 and a fourth region 624 having a width greater than or equal to the width of the second region 612. The second region 612 of the protrusion portion 610a may be inserted into the fourth region 624 of the guide portion 620, and thus, the dielectric plate 310 and the protective cover 520 may be stably coupled to each other. The guide portion 620b may be a trench type, and thus, the protective cover 520 may surround an entire first boundary surface 313 of the dielectric plate 310.

The trench type of guide portion 620b may have a tapered shape and a convex shape as described with reference to FIG. 6. Meanwhile, plasma generated in the substrate processing apparatus 1000 may intensively collide with an edge of the protective cover 520. The protective cover 520 according to an embodiment may include a round surface to reduce the collision with the plasma.

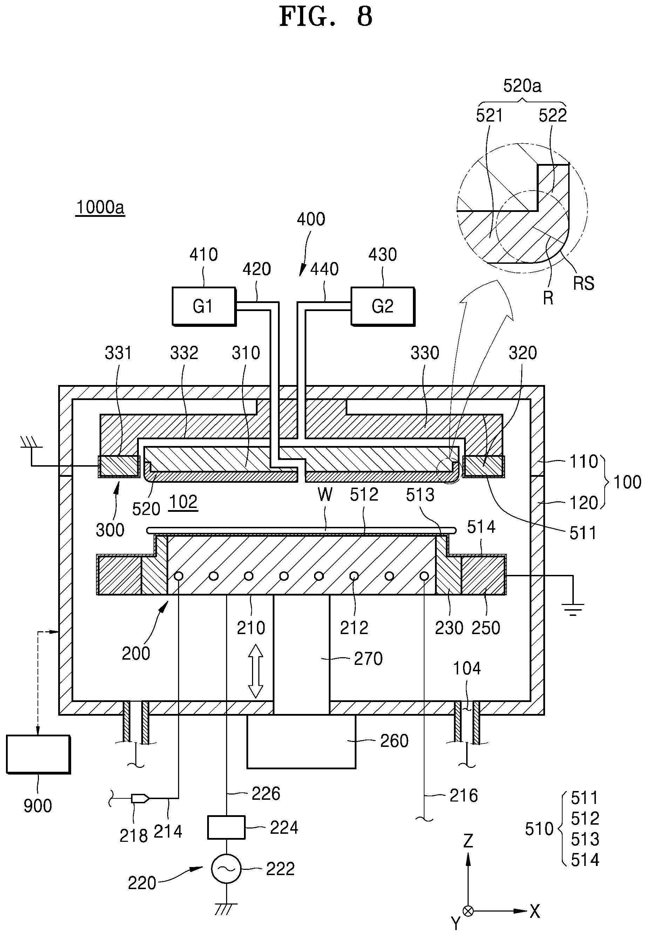

FIG. 8 is a view illustrating a substrate processing apparatus including a protective cover having a round surface, according to an embodiment. For brevity of description, the description of FIG. 8, which is substantially the same as the description of FIG. 2, is omitted.

A protective cover 520a may be attached to and detached from a dielectric plate 310 while the dielectric plate 310 is fixed to a housing 100. A coupling portion for coupling the protective cover 520b and the dielectric plate 310 to each other is as described with reference to FIGS. 5A to 7, and thus, a detailed description thereof is omitted. A material of the protective cover 520a may be the same as the material of the protective cover 520 described with reference FIG. 2, and thus, a detailed description thereof is omitted.

Referring to FIG. 8, the protective cover 520a may include a round surface RS that is convex toward a processing space 102. The round surface RS may be a surface that is not flat with respect to a particular plane and may have a convex shape toward the processing space 102. The round surface RS may be a surface connecting a side surface region 522 to a lower region 521. The round surface RS may have a radius of curvature R. Here, the radius of curvature R may be an average radius of curvature R of the round surface RS. However, the radius of curvature R is not limited thereto and may be the smallest value or the greatest value from among the radiuses of curvature R of the round surface RS. The radius of curvature R may be defined by a designer, a worker, or the like of a substrate processing apparatus 1000a.

The protective cover 520a may include the round surface RS, and thus, a chipping effect on plasma may be reduced. When the radius of curvature R of the round surface RS increases, the chipping effect on the plasma may be more effectively reduced. In contrast, when the radius of curvature R increases, the plasma colliding with the round surface RS may enter a central region of a substrate W and etch the central region of the substrate W. Accordingly, etching processing may performed up to a region of the substrate W on which the etching processing is not desired, and thus, a defect rate of the substrate W may increase. Therefore, the radius of curvature R may be limited to a range that reduces defects of the substrate W. The radius of curvature R may be about 10 mm or less. For example, the radius of curvature R may be about 1 mm to about 7 mm.

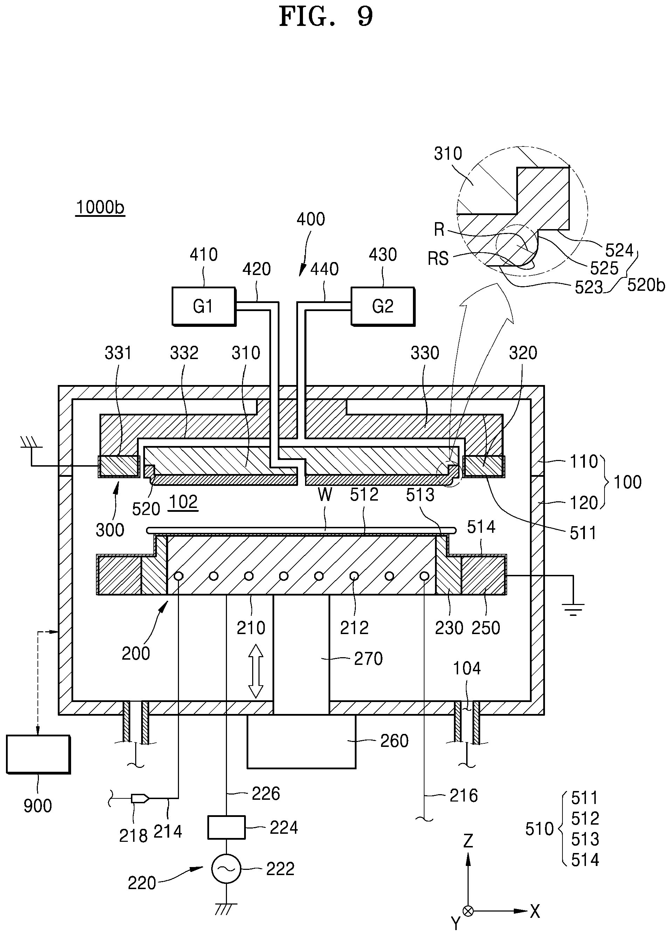

FIG. 9 is a view illustrating a substrate processing apparatus 1000b including a stepped protective cover 520b, according to an embodiment. For brevity of description, the description of FIG. 9, which is substantially the same as the description of FIG. 2, is omitted.

The protective cover 520b may be attached to and detached from a dielectric plate 310 while the dielectric plate 310 is fixed to a housing 100. A coupling portion for coupling the protective cover 520b and the dielectric plate 310 to each other is as described with reference to FIGS. 5A to 7, and thus, a detailed description thereof is omitted. A material of the protective cover 520b may be the same as the material of the protective cover 520 described with reference FIG. 2, and thus, a detailed description thereof is omitted.

Referring to FIG. 9, the protective cover 520b may have a stepped lower surface. For example, the lower surface of the protective cover 520b may include a third lower surface 523 and a fourth lower surface 524 that are parallel to a surface of a substrate W and have different gaps from the substrate W. In addition, the protective cover 520b may include a second boundary surface 525 connecting the third lower surface 523 to the fourth lower surface 524.

The gap between the third lower surface 523 and the substrate W may be different from the gap between the fourth lower surface 524 and the substrate W. For example, the gap between the third lower surface 523 and the substrate W may be smaller than the gap between the fourth lower surface 524 and the substrate W. When viewed from above, the third lower surface 523 may have a circular shape. Also, the second boundary surface 525 and the fourth lower surface 524 may have ring shapes. The second boundary surface 525 may be perpendicular to a surface direction of the substrate W. The second boundary surface 525 may be perpendicular to the surface direction of the substrate W, and thus, the second boundary surface 525 may also be referred to as a side surface of the protective cover 520b.

An inflow of plasma may be relatively smooth in a region below the fourth lower surface 524 of the protective cover 520b, and an inflow of plasma may be relatively suppressed in a region below the third lower surface 523, and thus, processing efficiency for an edge region of the substrate W may be improved.

The second boundary surface 525 may include the round surface RS that is convex toward the processing space 102. The entire surface of the second boundary surface 525 may be the round surface RS. However, the second boundary surface 525 is not limited thereto, and only a portion of the surface of the second boundary surface 525 may be the round surface RS. For example, from among the surface of the second boundary surface 525, a surface adjacent to the third lower surface 523 may be the round surface RS.

A radius of curvature R of the round surface RS may be limited by considering a chipping effect, a defect rate of the substrate W, and the like. The radius of curvature R may be about 10 mm or less. For example, the radius of curvature R may be about 1 mm to about 7 mm.

Meanwhile, the protective covers 520, 520a, and 520b may be damaged when a plasma processing process is performed. For example, when the number of plasma processing processes increases, the radius of curvature R of the protective covers 520, 520a, and 520b may be formed or the radius of curvature R may increase. A change in the radius of curvature R may change a region of the substrate W processed by the plasma. For example, the region of the substrate W processed by the plasma may increase when the substrate processing apparatuses 1000, 1000a, and 1000b operate. Process uniformity of the substrate processing apparatuses 1000, 1000a, and 1000b may be inhibited.

A substrate processing apparatus according to an embodiment may adjust a gap between the substrate W and a protective cover, e.g., the gap between the substrate W and lower surfaces (e.g., 513 and 523) of the protective cover, according to the radius of curvature R to uniformly maintain the processed region of the substrate W. The substrate processing apparatus according to an embodiment may reduce the gap between the substrate W and the protective cover when the radius of curvature R increases. The substrate processing apparatus according to an embodiment may also provide an indicator indicating that the protective cover needs to be replaced when the radius of curvature R is too great and thus a defect rate of the substrate W increases or when a deviation of the radius of curvature R is severe and thus the defect rate of the substrate W increases.

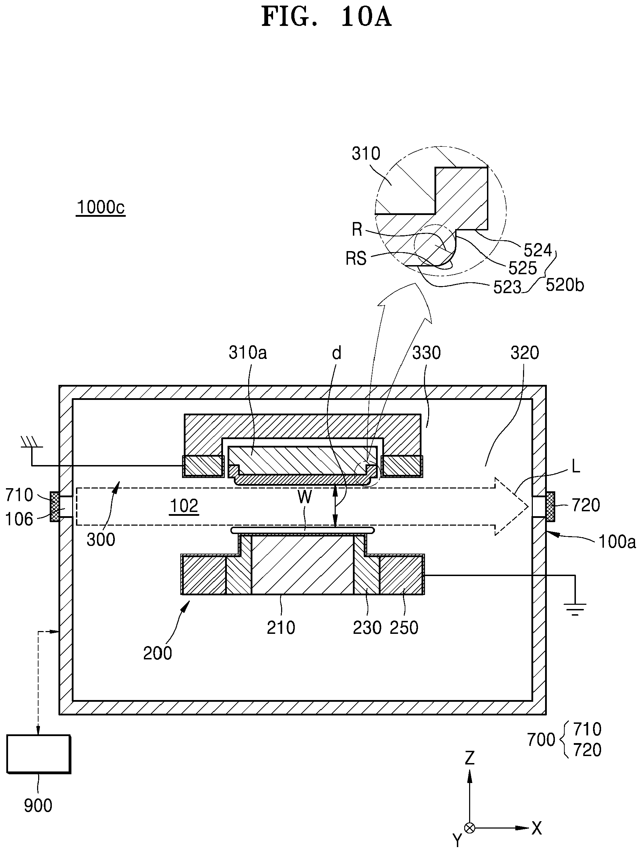

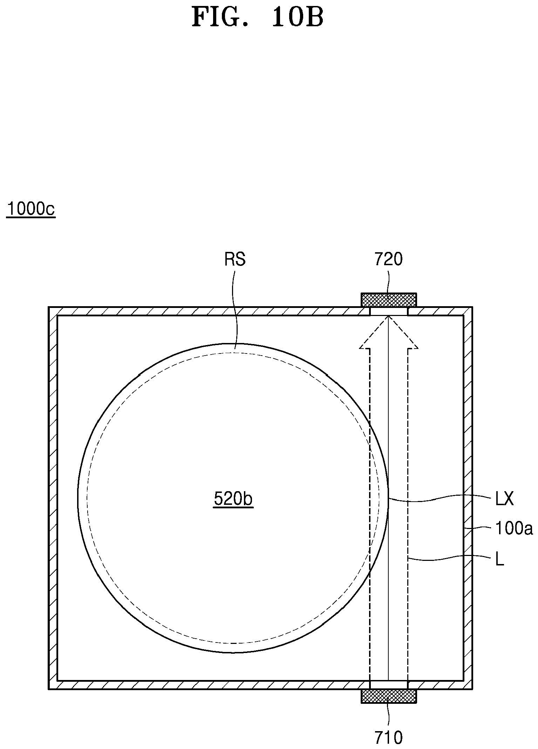

FIG. 10A is a view illustrating a substrate processing apparatus 1000c including an optical sensor 700, according to an embodiment, and FIG. 10B is a view schematically illustrating a relationship between a round surface RS and the optical sensor 700. For brevity of description, the description of FIGS. 10A and 10B, which is substantially the same as the description of FIG. 9, is omitted.

Referring to FIGS. 10A and 10B, a housing 100a may include a view port 106. The view port 106 may be a port including a transparent material so that a worker or the like may visually check a processing space 102 of the housing 100a, or the view port 106 may be provided on a sidewall of the housing 100a. A pair of view ports 106 may be provided to face each other.

The view port 106 may be arranged to overlap a protective cover 520b in a direction parallel to a lower surface of a dielectric plate 310. Alternatively, the view port 106 may be arranged not to overlap an upper surface of a chuck 210 in a direction parallel to the upper surface of the chuck 210. For example, an upper end of the view port 106 may be located higher than a second boundary surface 525 of the protective cover 520b, and a lower end of the view port 106 may be located higher than the upper surface of the chuck 210. However, the disclosure is not limited thereto. The lower end of the view port 106 may be located lower than the upper surface of the chuck 210.

The substrate processing apparatus 1000c according to an embodiment may further include the optical sensor 700 capable of acquiring a radius of curvature R of the protective cover 520b. For example, the optical sensor 700 may acquire the radius of curvature R of the round surface RS included in the protective cover 520b by using light. The optical sensor 700 may use light such as an LED or a laser having straightness.

The optical sensor 700 may include a light irradiator 710 and a photodetector 720. The light irradiator 710 and the photodetector 720 may be arranged at the view ports 106 described above. For example, the light irradiator 710 may be installed at one of a pair of view ports 106, and the photodetector 720 may be installed at the other one of the pair of view ports 106. In other words, light L, which is emitted by the light irradiator 710 to the processing space 102 through any one of the pair of view ports 106, may be transmitted to the photodetector 720 through the other one of the pair of view ports 106. The light irradiator 710 and the photodetector 720 may be arranged to face each other with the view ports 106 therebetween.

The light irradiator 710 may irradiate the light L. The photodetector 720 may detect the light L emitted by the light irradiator 710. The photodetector 720 may be arranged on a travel path of the light L irradiated by the light irradiator 710. As shown in FIG. 10B, the round surface RS of the protective cover 520 may be arranged on the travel path of the light L. For example, a light axis LX included in the travel path of the light L may be parallel to a tangential direction of the round surface RS. In addition, the travel path of the light L may overlap the round surface RS.

The light irradiator 710 may irradiate the light L toward the protective cover 520b in the processing space 102. The photodetector 720 may detect light, which travels through the processing space 102 without incident on the protective cover 520, from among the light L emitted by the light irradiator 710. For example, a portion of the light L irradiated by the light irradiator 710 may be blocked by the protective cover 520, in particular, by the round surface RS, and the other portion of the light L may pass through the processing space 102 and then be transmitted to the photodetector 720.

The photodetector 720 may include a processor (not shown) and may acquire the radius of curvature R of the round surface RS by using an amount of light detected, a location at which light is detected, and the like. The radius of curvature R may be acquired by using a shadow image technique. However, the disclosure is not limited thereto. A known technique may be applied to the method of acquiring the radius of curvature R by using light, and a detailed description thereof is omitted.

The optical sensor 700 may acquire the radius of curvature R, but is not limited thereto. The photodetector 720 may transmit information regarding detected light to the controller 900, and the controller 900 may acquire the radius of curvature R. Here, the controller 900 may be the processor of the optical sensor 700.

The optical sensor 700 may be fixed to the housing 100a, but is not limited thereto. The optical sensor 700 may be attached to or detached from the housing 100a. The optical sensor 700 may further include a driver (not shown), and the driver may rotate and move the light irradiator 710 and the photodetector 720 on the housing 100a. In addition, the optical sensor 700 may acquire the radius of curvature R with respect to the round surface RS at various locations. Alternatively, when the optical sensor 700 is fixed on the housing 100a and he housing 100a rotates or a dielectric plate 310 rotates, the optical sensor 700 may acquire the radius of curvature R of the round surface RS at various locations.

The optical sensor 700 may acquire the radius R of curvature of the round surface RS at a particular location and may acquire the radius of curvature R of the entire round surface RS. Alternatively, the optical sensor 700 may also acquire a standard deviation of the radius of curvature R.

The optical sensor 700 may acquire the radius of curvature R, but is not limited thereto. The optical sensor 700 may acquire a gap d between the protective cover 520 and the substrate W by using the detected light. The gap d between the protective cover 520 and the substrate W may also be acquired on the basis of an amount of light, a location of the detected light, and the like.

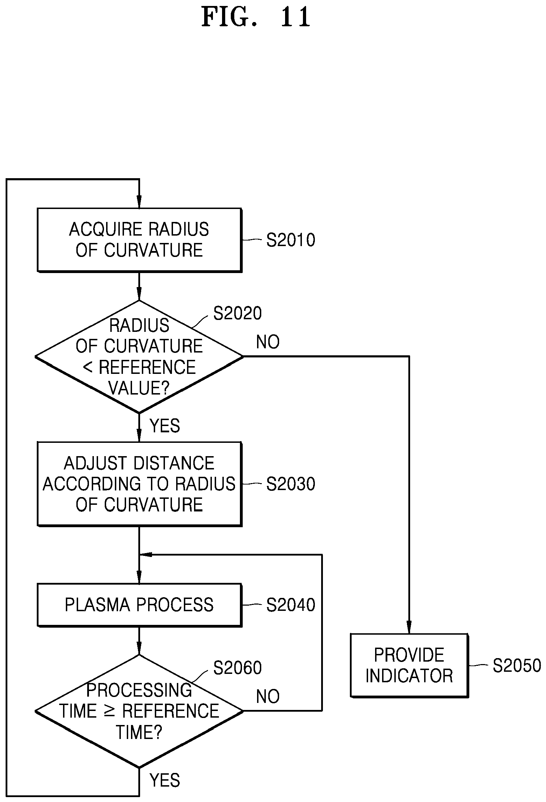

FIG. 11 is a flowchart illustrating a method of adjusting a gap between the protective cover 520b and the substrate W according to the radius of curvature R, according to an embodiment. Referring to FIGS. 10A, 10B, and 11, in operation S2010, the optical sensor 700 may acquire the radius of curvature R with respect to the round surface RS. The optical sensor 700 includes the light irradiator 710 and the photodetector 720, and the round surface RS may be arranged on the travel path of the light L. For example, the light axis LX of the travel path of the light L may be parallel to the tangential direction of the round surface RS, and a partial region of the round surface RS may overlap a portion of the travel path of the light L.

The optical sensor 700 may acquire the radius of curvature R on the basis of a location of the detected light and an amount of light. However, the disclosure is not limited thereto. The photodetector 720 may transmit information regarding the detected light to the controller 900, and the controller 900 may acquire the radius of curvature R. The radius of curvature R may be a radius of curvature R pf a particular location on the round surface RS. However, the radius of curvature R is not limited thereto and may also be an average of radiuses of curvature R acquired at a plurality of locations on the round surface RS. The radiuses of curvature R acquired at the plurality of locations may be acquired when at least one of the optical sensor 700, the housing 100a, and the dielectric plate 310 rotates.

In operation S2020, the controller 900 may determine whether or not the radius of curvature R is less than a reference value. Here, the reference value may be a range in which the substrate W may not be effectively processed even when the gap d between the substrate W and the protective cover 520b is adjusted, i.e., a range in which the processed substrate W is defective. The reference value may refer to the radius of curvature R when the number of substrates W processed as defective is greater than or equal to a certain number. For example, the reference value may be about 10 mm. However, the reference value is not limited thereto and may be adjusted by a designer, a worker, or the like of the substrate processing apparatus 1000c.

When the radius of curvature R is less than the reference value in operation S2020, in operation S2030, the controller 900 may adjust the gap d between the substrate W and the protective cover 520b such that the gap d between the substrate W and the protective cover 520b is a target gap. The memory 920 of the controller 900 may pre-store, as a lookup table, information regarding the target gap corresponding to the radius of curvature R. The radius of curvature R and the target gap may correspond to each other on a one-to-one basis, and the radius of curvature R and the target gap may be inversely proportional to each other. When a plurality of ranges of processed regions of the substrate W are provided, the target gap corresponding to the radius of curvature R may be matched and stored for each range of the processed regions. The controller 900 may read the target gap corresponding to the acquired radius of curvature R from the lookup table stored in the memory 920, and control the actuator 260 such that the gap d between the substrate W and the protective cover 520b is the target gap.

When the gap d between the substrate W and the protective cover 520b is adjusted to the target gap, in operation S2040, the substrate processing apparatus 1000c may generate plasma to process the substrate W. For example, the substrate processing apparatus 1000c may process the substrate W by supplying a process gas and generating plasma from the supplied process gas. The substrate processing apparatus 1000c may process an edge region of the substrate W by supplying a process gas and generate plasma from the supplied process gas.

The optical sensor 700 may further measure the gap d between the substrate W and the protective cover 520b to check whether or not the gap d between the substrate W and the protective cover 520b is the target gap and apply the result thereof to the controller 900. When a difference between the gap d between the substrate W and the protective cover 520b and the target gap is within an error range, operation S2040 may be performed. When the difference between the gap d between the substrate W and the protective cover 520 and the target gap is out of the error range, the controller 900 may readjust the gap d between the substrate W and the protective cover 520b.

When the radius of curvature R is greater than or equal to the reference value, in operation S2050, the controller 900 may output an indicator indicating that the life of the protective cover 520b expires. The indicator may be output in the form of an image, light, or text through the output unit 940 of the controller 900. When the radius of curvature R is greater than or equal to the reference value, the number of substrates W processed as defective may be greater than or equal to a certain number even when the gap d between the substrate W and the protective cover 520b is adjusted. The above description may indicate that the life of the protective cover 520b expires. Therefore, a defect rate of the substrate W may be reduced by notifying the worker or the like that the protective cover 520 needs to be replaced.

In operation S2060, the controller 900 may determine whether or not a plasma processing period is greater than or equal to a reference time. The reference time may be a time when deformation of the radius of curvature R is expected by plasma processing. The plasma processing may be performed continuously or discontinuously. The plasma processing time may be a sum of times at which the plasma processing is performed.

When the plasma processing time is greater than or equal to the reference time in operation S2060, the substrate processing apparatus 1000 may repeatedly perform the processes of acquiring the radius of curvature R of the round surface RS, adjusting the gap d between the substrate W and the protective cover 520 to correspond to the acquired radius of curvature R, and then performing the plasma processing process.

As described with reference to FIG. 11, when the radius of curvature R is greater than or equal to the reference value, the indicator may be provided, but the disclosure is not limited thereto. Even when a standard deviation of the radius of curvature R is greater than or equal to a certain value, the above-described indicator may be provided. Accordingly, when the standard deviation of the radius of curvature (R) is great, a uniform process capability may not be easily expected.

As described above, the substrate W may be plasma-processed after adjusting the gap d between the substrate W and the protective cover 520b according to the radius of curvature R, and thus, the uniform process capability of the substrate processing apparatus 1000c may be maintained. In addition, even when the radius of curvature R is changed, the protective cover 520b may be used for a long time, and thus, a maintenance cost of the substrate processing apparatus 1000c may be reduced.

The method of adjusting the gap d between the substrate W and the protective cover 520 according to the radius of curvature R of the protective cover 520b has been described on the basis of the substrate processing apparatus 1000c shown in FIGS. 10A and 10B, but is not limited thereto. The method of adjusting the gap d between the substrate W and the protective cover 520b according to the radius of curvature R of the protective cover 520b may also be applied to the substrate processing apparatuses 1000 and 1000a including the protective covers 520 and 520a. In addition, although not shown in the drawings, the method may also be applied to a substrate processing apparatus that performs a plasma processing process while including a protective cover, according to an embodiment.

The method of generating plasma by the substrate processing apparatuses 1000, 1000a, 1000b, and 1000c described in the above example may be an inductive coupled plasma (ICP) method. Alternatively, the method of generating plasma by the substrate processing apparatus 1000 described above may be a capacitor couple plasma (CCP) method. Alternatively, the substrate processing apparatuses 1000, 1000a, 1000b, and 1000c may generate plasma by using both the ICP method and the CCP method or by using a method selected from the ICP method and the CCP method. Alternatively, the substrate processing apparatuses 1000, 1000a, 1000b, and 1000c may generate plasma by using a remote plasma method.

According to an embodiment, a substrate processing apparatus may prevent a component from being damaged by arranging a protective cover having high plasma resistance on the component that is highly likely to collide with plasma within a housing.

According to an embodiment, the substrate processing apparatus may easily attach and detach the protective cover while an other component within the substrate processing apparatus is fixed.

According to an embodiment, a uniform process capability for a substrate may be maintained by adjusting a gap between the substrate and the protective cover according to a radius of curvature of a protective cover.

According to an embodiment, the use life of the protective cover may increase by adjusting the gap between the substrate and the protective cover according to the radius of curvature of the protective cover.

According to an embodiment, the uniform process capability for the substrate may be maintained by adjusting the gap between the substrate and the protective cover according to the radius of curvature of the protective cover.

According to an embodiment, a maintenance cost of the substrate processing apparatus may be reduced by adjusting the gap between the substrate and the protective cover according to the radius of curvature of the protective cover.

Effects of the disclosure are not limited to the above-described effects, and effects not mentioned may be clearly understood by one of ordinary skill in the art to which the disclosure pertains from the description and accompanying drawings.

Although the substrate processing apparatuses 1000, 1000a, 1000b, and 1000c are only illustrative, one of ordinary skill in the art may understand that various modifications and equivalent other embodiments may be made therefrom. It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the disclosure as defined by the following claims.

## Claims

1. An apparatus for processing a substrate, the apparatus comprising:
a housing defining a processing space;
a chuck arranged in the processing space and supporting the substrate;
a dielectric plate spaced apart from the chuck with the substrate therebetween;
a lower edge electrode arranged to surround the chuck;
an upper edge electrode surrounding a side surface of the dielectric plate and arranged to face the lower edge electrode;
a gas supply unit configured to supply a process gas for plasma processing an edge region of the substrate;
a protective cover covering an entire lower surface of the dielectric plate, attachable to and detachable from the dielectric plate, and protecting the dielectric plate from the plasma; and
a coupling portion attaching and detaching the protective cover to and from the dielectric plate.

2. The apparatus of claim 1, wherein the protective cover comprises a material comprising at least two of Nd, Pm, Sm, Gd, Y, Sc, Er, F, and O.

3. The apparatus of claim 1 or 2, wherein a lower surface of the protective cover has a stepped shape, and the protective cover comprises a round surface convex toward the processing space.

4. The apparatus of claim 3, wherein a radius of curvature of the round surface is 10 mm or less.

5. The apparatus of claim 3 or 4, wherein a gap between the substrate and the protective cover is adjusted to be inversely proportional to the radius of curvature of the round surface.

6. The apparatus of any one of claims 3 to 5, further comprising an optical sensor arranged on the housing and configured to acquire the radius of curvature of the round surface by using light.

7. The apparatus of any one of claims 1 to 6, wherein the coupling portion comprises:
a protrusion portion arranged on a side surface of the dielectric plate and protruding outwards; and
a guide portion arranged on a side surface region of the protective cover and providing a movement path of the protrusion portion while the protrusion portion is inserted thereinto.

8. The apparatus of claim 7, wherein the guide portion comprises:
a first guide portion comprising one end exposed at an upper end of the protective cover and extending in a direction perpendicular to the lower surface of the protective cover; and
a second guide portion comprising one end connected to an other end of the first guide portion and extending in a direction parallel to the lower surface of the protective cover.

9. The apparatus of claim 7 or 8, wherein the guide portion has a non-uniform width.

10. The apparatus of any one of claims 1 to 9, wherein the protective cover is attached to and detached from the dielectric plate while the dielectric plate and the upper edge electrode are fixed to the housing.
